# EUROPEAN PATENT SPECIFICATION

(11) **EP 1 434 276 B1**
(45) Date of publication and mention of the grant of the patent: **01.07.2009**
(21) Application number: 03256671.3
(22) Date of filing: 23.10.2003
(51) Int. Cl.: H01L 27/146, H01L 31/0203

(54) **Image sensor adapted for reduced component chip scale packaging**
Angepasster Bildsensor für eine Packung in Chip-Grösse
Capteur d'images adapté pour l'empaquetage à l'échelle de la puce

(30) Priority: 26.12.2002 US 330824
(43) Date of publication of application: 30.06.2004
(73) Proprietor: OmniVision International Holding Ltd, George Town Grand Cayman (KY)
(72) Inventor: Yamamoto, Katsumi, Shanghai 200031 (CN)
(74) Representative: Hackney, Nigel John

(56) References cited:
- EP-A- 1 041 628
- US-B1- 6 285 064
- PATENT ABSTRACTS OF JAPAN vol. 1999, no. 09, 30 July 1999 (1999-07-30) -& JP 11 121653 A (FUJI FILM MICRODEVICES CO LTD;FUJI PHOTO FILM CO LTD), 30 April 1999 (1999-04-30)
- PATENT ABSTRACTS OF JAPAN vol. 1998, no. 01, 30 January 1998 (1998-01-30) -& JP 09 232551 A (TOSHIBA CORP), 5 September 1997 (1997-09-05)
- LU B ET AL: "ACTIVE PIXEL SENSOR (APS) PACKAGE" PROCEEDINGS OF THE SPIE, SPIE, BELLINGHAM, VA, US, vol. 3830, 1999, pages 175-178, XP000980682 ISSN: 0277-786X

## Description

### TECHNICAL FIELD OF THE INVENTION

The present invention is related to image sensing integrated circuits, and more particularly, to a simplified chip scale package for image sensors.

### BACKGROUND INFORMATION

Image sensors are now extensively used in many applications ranging from cell phone cameras, PC cameras, digital still cameras, and security cameras. Most of these applications require that the image sensor withstand varying environmental conditions. Because of this, chip package solutions for image sensors have been developed to protect the image sensor from environmental factors.

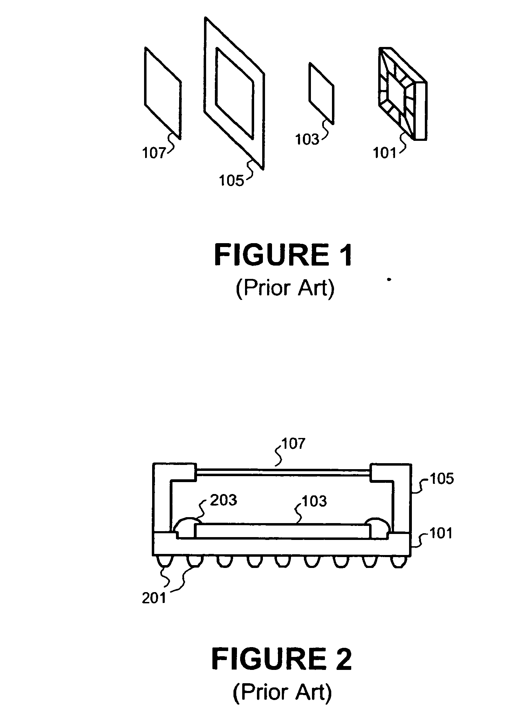

A prior art structure is shown in Figure 1 in exploded isometric view. Figure 2 shows the structure of Figure 1 in assembled cross-section view. The chip package includes a substrate 101 that has incorporated a lead frame. The image sensor 103 is adhered to the substrate 101. The lead frame is then wire bonded to contact pads on the image sensor 103. A cap or spacer 105 is then secured to the lead frame in order to provide spacing between a glass lid 107 and the image sensor 103. The glass lid 107 is required to allow transparent optical imaging by the image sensor 103 to the outside world. Additionally, the glass lid 107 and the spacer 105 serve to prevent environmental contaminants from affecting the operation of the image sensor 103.

The lead frame/substrate 101 provides a means by which signals can be read out from the image sensor 103. In one conventional prior art configuration, the substrate is a ceramic substrate and thus referred to as a ceramic package. Examples of various types of packaging techniques for image sensor are shown in U.S. Patent Application Publication No. 2002/0079438 to Lin, U.S. Patent Application Publication No. 2002/0140072 to Chiu, U.S. Patent Application Publication No. 2002/0148946 to Tu et al., and U.S. Patent Application Publication No. 2002/0006687 to Lam. In each of these disclosures, multiple components are required to mount the image sensor onto a substrate and protect the image sensor with a glass lid.

However, the use of so many components increases the cost of packaging. Therefore, it is desirable to decrease the packaging costs for image sensors.

European Patent Application No. EP1041628 discloses an image sensor packaging technique based on a Ball Grid Array (BGA) integrated circuit packaging technique in which a transparent cover is attached to a semiconductor substrate to obtain a hermetic or non-hermetic sealing.

US Patent No, US6,285,064 discloses a chip scale packaging for optical Image sensor integrated circuit in which micro lenses are placed on top of a wafer having the image sensors formed thereon.

Japanese Patent Application No. JP11-121653 discloses a semiconductor device In which a semiconductor chip is mounted on a transparent substrate so that there is a hollow part between the semiconductor chip and the transparent substrate.

Lu B et al: "Active Pixel Sensor (APS) Package", Proceedings of the SPIE, vol. 3830, 999, pages 175-178 discloses two types of special chip-scale packages: ceramic, land-grld-array packages and plastic moulded packages.

Accordingly, in a first aspect, the present invention provides a method of forming Image sensor dies according to claim 1 and an image sensor die according to claim 5.

### BRIEF DESCRIPTION OF THE DRAWINGS

Figure 1 is a prior art chip scale packaging technique for image sensor integrated circuits.

Figure 2 is a cross-section view of the prior art structure of Figure 1 that has been assembled.

Figure 3 is a top view of an image sensor die formed in accordance with the prior art.

Figure 4 is a cross-section of the image sensor die of Figure 3 taken along line A-A'.

Figure 5 is a top view of an example of an image sensor die which is not covered by the claims but is useful for understanding the invention.

Figure 6 is a cross-section of the image sensor die of Figure 5 taken along line B-B'.

Figure 7 is an example of an image sensor die which is not covered by the claims but is useful for understanding the invention with a glass lid attached.

Figure 8 shows an example of an image sensor die which is not covered by the claims but is useful for understanding the invention mounted onto a flexible tape.

### DETAILED DESCRIPTION

In the following description, numerous specific details are provided to provide a thorough understanding of the embodiments of the invention. One skilled in the relevant art will recognize, however, that the invention can be practiced without one or more of the specific details, or with other methods, components, etc. In other instances, well-known structures or operations are not shown or described in detail to avoid obscuring aspects of various embodiments of the invention.

Reference throughout the specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout the specification are not necessarily all referring to the same embodiment. Furthermore, the particular features, structures, or characteristics may be combined in any suitable manner in one or more embodiments.

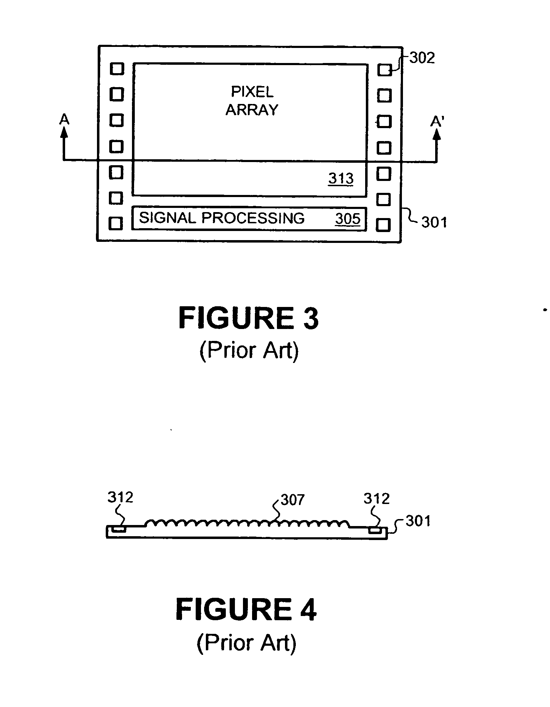

In accordance with the present invention, an image sensor is formed that includes structures on the image sensor die that aid in simplifying the packaging of the image sensor die. Figure 3 shows a prior art image sensor die 301 that includes a pixel array 303 and a signal processing block 305. Both the pixel array 303 and the signal processing block 305 are formed on the die 301. Other circuitry (such as input/output buffers, drivers, and other components) are typically present on the die 301, but are not shown to avoid obscuring the present invention.

A cross-section taken along line A-A' is shown in Figure 4. The image sensor die 301 includes microlenses 307 that are formed atop of each pixel in the pixel array. The microlenses 307 are present to aid in increasing the fill factor of each pixel. Also shown in Figures 3 and 4 are bonding pads 302 that are formed into the substrate of the die 301. The bonding pads 302 are also referred to as contact pads and are used for wire bonding the image sensor die 301 to the lead frame 101 of Figure 1.

The prior art image sensor die 301 of Figures 3 and 4 requires the multiple component chip scale package shown in Figures 1 and 2. As noted earlier, because of the multiple components required to package this image sensor die 301, the cost is relatively high.

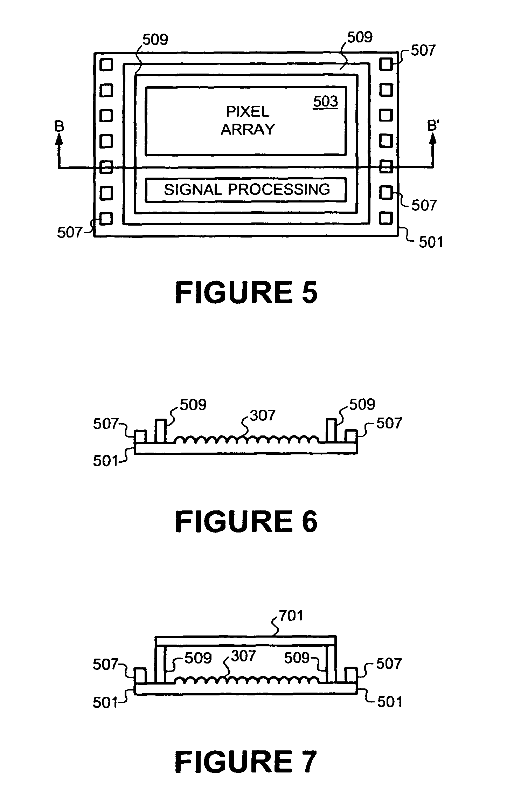

Figures 5 and 6 illustrate an example of an image sensor die. The core areas of the die 501 remain the same, i.e., the pixel array 503 and the signal processing block remain as in the prior art.

Further, the structure of the pixel area 503, the signal processing block, and other circuit structures are well known in the art. For example, the assignee of the present application, OmniVision Technologies, Inc., is the owner of several patents detailing the formation of an image sensor die. The present invention is directed towards modifying those prior art image sensor dies with additional structures in order to more efficiently provide chip scale packaging.

However, additional features are provided that make packaging of the die 501 much simpler. First, instead of contact pads 302, stack bumps 507 are present along the peripheral regions of the die 501.

The stack bumps 507 are typically formed from a conductive material, such as aluminum, tungsten, copper, titanium, or the like. In one embodiment, the stack bumps 507 are formed by a deposition and etch process. However, other methods for forming the stack bumps 507 are suitable. In the invention, the stack bumps 507 are raised above the surface of the image sensor die, and typically raised well above the surface of the microlenses 307. The stack bumps 507 serve to propagate signals output by the image sensor die 501 to either a printed circuit board or other packaging system. Therefore, the stack bumps 507 can be directly attached to a printed circuit board, similar to a ball grid array (BGA) connection technique.

Additionally, a spacer ring 509 is formed around the pixel array 503. The purpose of the spacer ring 509 is to support a glass lid 701 (see Figure 7) that will form a seal and protect the pixel array 503. The term glass lid as used herein is not limited to a glass material, but refers to any material that is substantially transparent to radiation having a selected wavelength.

In some embodiments, the spacer ring 509 extends around the entire periphery of the image sensor die 501, encompassing nearly all of the circuitry except for the stack bumps 507. In the invention, the spacer ring 507 only surrounds the pixel array 503 and the glass lid 701 is sized to coincide with the shape of the spacer ring 509. The material used to form the spacer ring is variable, but preferably should not be a conducting material.

The material to form the spacer ring 509 should be easily formed onto an image sensor die 501 using conventional semiconductor processes. For example, an oxide or other dielectric material may be used. The formation of the spacer ring 509 can be performed using conventional semiconductor techniques including deposition, masking, and etching. Alternatively, the spacer ring 509 can be formed by direct printing or dispensing.

As seen in Figures 6 and 7, the spacer ring 509 should extend above the microlenses 307 such that the glass lid 701 is not in contact with the microlenses 307. Although the spacer ring 509 is shown to be taller than the stack bumps 507, in embodiments of the invention, the spacer ring 509 has a lesser height than the stack bumps 507.

Other types of materials suitable for use for the spacer ring 509 are epoxies, polyimides, or resins. The advantage of an epoxy is that the glass lid 701 can be secured directly to the spacer ring 509. The glass lid 701 may be secured to the spacer ring 509 either prior to or after the image sensor die 501 have been diced into individual units out of the wafer. In one embodiment, the glass lid 701 is secured to the individual image sensor die 501 prior to dicing. This has the advantage of minimizing or eliminating particulate contamination of the pixel array during the dicing process.

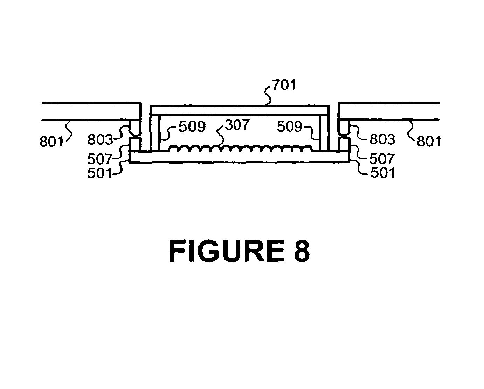

Turning next to Figure 8, the image sensor die with glass lid of Figure 7 can then be further packaged to a printed circuit board or a flexible tape. In Figure 8, a flexible tape 801 includes connectors 803 that can be electrically attached to the stack bumps 507, by any number of conventional means. Further, although a flexible tape 801 is shown, a printed circuit board can easily be substituted therefore.

Thus, to summarize, the present invention discloses an image sensor die that has structures intended to more efficiently package the image sensor die. The structures include a spacer ring and stack bumps. The spacer ring serves to support a glass lid over the pixel array of the image sensor die. The stack bumps are raised in order to facilitate direct connection to flexible tape or a printed circuit board.

Further, a method for forming image sensor dies is disclosed. The method comprises forming a plurality of image sensor dies onto a semiconductor wafer. The image sensor die include a spacer ring structure and stack bumps. Glass lids are placed onto the spacer ring to seal and protect the pixel array. The wafer is then diced into individual image sensor die. Following dicing, the individual image sensor die are then packaged further by attaching, through the stack bumps, to a flexible tape or a printed circuit board, or in fact any other type of structural apparatus.

The above description of illustrated image sensor dies is not intended to be exhaustive or to limit the invention to the precise forms disclosed. While specific embodiments of, and examples for, the invention are described herein for illustrative purposes, various equivalent modifications are possible within the scope of the invention, as those skilled in the relevant art will recognize. These modifications can be made to the invention in light of the above detailed description. The terms used in the following claims should not be construed to limit the invention to the specific embodiments disclosed in the specification. Rather, the scope of the invention is to be determined entirely by the following claims that are to be construed with accordance with established doctrines of claim interpretation.

## Claims

1. A method comprising:
forming a plurality of image sensor die (501) on a semiconductor wafer, said plurality of image sensor die having a spacer ring (509) surrounding a pixel array (503) on said image sensor die;
placing a glass lid onto said spacer ring, said glass lid (701) being secured to said spacer ring and sized to coincide with the shape of the spacer ring;
dicing said wafer into individual image sensor die; and
forming stack bumps (507) of a conductive material onto said plurality of image sensor die (501), said stack bumps being raised ; relative to the surface of said image sensor die;
**characterized in that** said stack bumps (507) are taller than said spacer ring (509).

2. The method of Claim 1 further including attaching said image sensor die (501) to a flexible tape (801) or printed circuit board through said stack bumps.

3. The method of Claim 1 wherein said spacer ring (509) is formed from a polyimide.

4. The method of Claim 1 wherein said spacer ring (509) is formed from a resin or an epoxy.

5. An image sensor die (501) comprising: :
a pixel array (503);
a signal processing block;
a spacer ring (509) encompassing said pixel array;
a glass lid (701) secured to the spacer ring and sized to : coincide with the shape of the spacer ring; and
stack bumps (507) of a conductive material that are raised above the surface of said image sensor die;
**characterized in that** said stack bumps (501) are taller than said spacer ring (509).

6. The image sensor of Claim 5 wherein said image sensor die (501) is attached to a flexible tape (801) or printed circuit board through said stack bumps (507).

7. The image sensor die (501) of Claim 5 wherein said spacer ring (509) is formed from a polyimide.

8. The image sensor die (501) of Claim 5 wherein said spacer ring (509) is formed from a resin or an epoxy.

## Patentansprüche

1. Verfahren, umfassend:
das Ausbilden einer Vielzahl an Bildsensor-Mikrobauelementen (501) auf einem Halbleiterwafer, wobei die Vielzahl an Bildsensor-Mikrobauelementen einen Abstandsring (509) aufweist, der eine Bildpunktmatrix (503) auf dem Bildsensor-Mikrobauelement umgibt;
das Platzieren eines Glasdeckels auf dem Abstandsring, wobei der Glasdeckel (701) an dem Abstandsring befestigt wird und so dimensioniert ist, dass er mit der Form des Abstandsrings übereinstimmt;
das Zerteilen des Wafers in einzelne Bildsensor-Mikrobauelemente und
das Ausbilden von Stapel-Bump-Kontakten (507) aus einem leitfähigen Material auf der Vielzahl der Bildsensor-Mikrobauelemente (501), wobei die Stapel-Bump-Kontakte in Bezug auf die Oberfläche der Bildsensor-Mikrobauelemente erhaben sind;
**dadurch gekennzeichnet, dass** die Stapel-Bump-Kontakte (507) höher sind als der Abstandsring (509).

2. Verfahren nach Anspruch 1, ferner umfassend das Befestigen des Bildsensor-Mikrobauelements (501) an einem flexiblen Band (801) oder einer Leiterplatte mit Hilfe der Stapel-Bump-Kontakte.

3. Verfahren nach Anspruch 1, worin der Abstandsring (509) aus einem Polyimid hergestellt wird.

4. Verfahren nach Anspruch 1, worin der Abstandring (509) aus einem Harz oder einem Epoxy hergestellt wird.

5. Bildsensor-Mikrobauelement(501), umfassend:
eine Bildpunkte-Matrix (503);
einen Signalverarbeitungsblock;
einen Abstandsring (509), der die Bildpunkte-Matrix umgibt;
einen Glasdeckel (701), der an dem Abstandsring befestigt wird und so dimensioniert ist, dass er mit der Form des Abstandsrings übereinstimmt; und
Stapel-Bump-Kontakte (507) aus einem leitfähigen Material, die in Bezug auf die Oberfläche des Bildsensor-Mikrobauelements erhaben sind;
**dadurch gekennzeichnet, dass** die Stapel-Bump-Kontakte (507) höher sind als der Abstandsring (509).

6. Bildsensor nach Anspruch 5, worin das Bildsensor-Mikrobauelement (501) mit Hilfe der Stapel-Bump-Kontakte (507) an einem flexiblen Band (801) oder einer Leiterplatte befestigt ist.

7. Bildsensor-Mikrobauelement (501) nach Anspruch 5, worin der Abstandsring (509) aus einem Polyimid hergestellt ist.

8. Bildsensor-Mikrobauelement (501) nach Anspruch 5, worin der Abstandsring (509) aus einem Harz oder einem Epoxy hergestellt ist.

## Revendications

1. Procédé comprenant:
former une pluralité de matrices de capteur d'images (501) sur une plaquette en semi-conducteur, ladite pluralité de matrices de capteur d'images ayant une bague d'écartement (509) entourant un groupement de pixels (503) sur ladite matrice de capteur d'images;
placer un couvercle en verre sur ladite bague d'écartement, ledit couvercle en verre (701) étant fixé à ladite bague d'écartement et étant dimensionné pour coïncider avec la forme de la bague d'écartement;
trancher ladite plaquette en matrices de capteur d'images individuelles; et
former des bosses d'empilage (507) en un matériau conducteur sur ladite pluralité de matrices de capteur d'images (501), lesdites bosses d'empilage étant relevées relativement à la surface de ladite matrice de capteur d'images;
**caractérisé en ce que** lesdites bosses d'empilage (507) sont plus hautes que ladite bague d'écartement (509).

2. Procédé selon la revendication 1, comprenant en outre la fixation de ladite matrice de capteur d'images (501) sur une bande flexible (801) ou carte de circuit imprimé par lesdites bosses d'empilage.

3. Procédé selon la revendication 1, dans lequel ladite bague d'écartement (509) est réalisée en un polyimide.

4. Procédé selon la revendication 1, dans lequel ladite bague d'écartement (509) est réalisée en une résine ou une époxy.

5. Matrice de capteur d'images (501) comprenant:
un groupement de pixels (503);
un bloc de traitement de signaux;
une bague d'écartement (509) entourant ledit groupement de pixels;
un couvercle en verre (701) fixé sur ladite bague d'écartement et dimensionné pour coïncider avec la forme de la bague d'écartement; et
des bosses d'empilage (507) en un matériau conducteur qui s'élèvent au-delà de la surface de la matrice de capteur d'images précitée;
**caractérisé en ce que** lesdites bosses d'empilage (501) sont plus hautes que ladite bague d'écartement (509).

6. Capteur d'images selon la revendication 5, où ladite matrice de capteur d'images (501) est fixée à une bande flexible (801) ou une carte de circuit imprimé par lesdites bosses d'empilage (507).

7. Matrice de capteur d'images (501) selon la revendication 5, où ladite bague d'écartement (509) est réalisée en un polyimide.

8. Matrice de capteur d'images (501) selon la revendication 5, où ladite bague d'écartement (509) est réalisée en une résine ou un époxy.
